(19) Europäisches Patentamt

European Patent Office

Office européen des brevets

(11) **EP 3 392 132 A1**

(12) **EUROPEAN PATENT APPLICATION**

(43) Date of publication:
24.10.2018 Bulletin 2018/43

(51) Int Cl.:
***B63H 21/21*** *(2006.01)*

(21) Application number: 18167421.9

(22) Date of filing: 16.04.2018

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.04.2017 IT 201700042877**

(71) Applicant: **Ultraflex Spa
16015 Casella (GE) (IT)**

(72) Inventors:
• **GAI, Marcella**
**16136 GENOVA (IT)**
• **CAMPAGNA, Marco**
**I-16137 Genova (IT)**
• **VACCARI, Marco**
**I-16131 Genova (IT)**

(74) Representative: **Karaghiosoff, Giorgio
Alessandro
c/o Praxi Intellectual Property S.p.A. - Savona
Via F. Baracca 1R, 4° piano
"Il Gabbiano"
17100 Savona (IT)**

(54) **CONTROL DEVICE FOR BOATS**

(57)     Device (7) for controlling reverse gears, particularly of marine engines, comprising a fixed part (1) and a movable part (2) , the movable part being provided for being rotatably coupled to a control member (6) having at least three operating states corresponding to a first, a second and a third angular position of the movable part of the devic. The fixed part (1) comprises at least a first (101) and a second sensor (201) for example of the type generating a voltage when subjected to an external magnetic field due to Hall effect, which are arranged at predetermined distance and able to detect the presence of a magnetic field. The movable part (2) comprises a magnet (102) with such characteristics to generate a magnetic field detected by the first (101) or second sensor (201) when the movable part is in the first or in the second position respectively or vice versa, the third position corresponding to a situation of absence of magnetic field detectable by the sensors.

Fig. 2

## Description

TEXT OF THE DESCRIPTION

Object of the invention is a control device, particularly for boats.

Such devices are currently used in the boats to regulate, for example, the operating conditions of the motors through control members, typically levers, movable along a predetermined path and for a predetermined travel between the two extreme stop positions, mechanically connected, for example with a lever or rod or flexible cable system, to members movably regulating the operating conditions of the motors, such as for example a butterfly valve or a lever controlling the reverse gear and intended for reverting the run direction of the boat.

An alternative to these mechanical systems is represented by electromechanical systems such as those described in US 5466996 or by the electronic systems as described, for example, in US 6587765.

In these systems in practice sensors are used to detect the position of the control levers and send corresponding actuation commands through electronic central units.

In the specific case of driving the reverse gears, in addition to solutions with pair of levers or single-lever, systems are known wherein the forward or reverse command are given to a pair of switches arranged on the bridge of the boat, which switches separately drive motorized actuators moving the engaging lever of the inverter in a direction or in the opposite one to allow the rotation of the propeller in the opposed directions.

In practice, when a gear has to be shifted, the switch corresponding to the desired direction is activated. If the opposite gear has to be shifted, the previously activated switch has to be deactivated and, thus, the other switch has to be activated. This since the reverse gear has always to be brought back to a neutral position before changing the rotation of the propeller.

This is particularly tricky.

Object of the present invention is a device able to provide, in a simple and cost effective way, the commands activating the reverse gear without the need of using separated switches or complex logics of functioning.

The invention reaches the object with a device for controlling reverse gears, particularly of marine engines, comprising a fixed part and a movable part, the movable part being provided for being rotatably coupled, i.e. coupled in rotation, to a control member having at least three operating states corresponding to a first, a second and a third angular position of the movable part of the device. The fixed part comprises at least one first and one second sensor, for example of the type generating a voltage when subjected to an external magnetic field due to Hall effect, which are arranged at predetermined distance and able to detect the presence of a magnetic field. The movable part comprises a magnet with such characteristics to generate a magnetic field detected by the first or second sensors when the movable part is in the first or second positions respectively or vice versa, the third position corresponding to a situation of absence of magnetic field detectable by the sensors.

The device is specifically advantageous since it does not need any supporting Boolean logic, the magnet position determining the sequence of activation of the sensors and, thus, commands.

Indeed the sensors can only be excited separately and a control can be activated only after the previous control has been deactivated, thus inherently ensuring the automatic passage from the neutral condition essential for the operation of marine engines.

According to an embodiment, the magnet is integral with an element intended to rotate about an axis such to generate a rotating magnetic field with constant strength, the sensors being arranged in staggered angular positions such that the magnetic field interferes with the operating range of the sensors when the magnet is in proximity of said sensors.

The magnet can be advantageously oriented with the poles parallel to the axis of rotation. In this way the magnetic field takes the direction of the generatrix of a cylinder with circular base with radius equal to the distance of the magnet from the axis of rotation. The sensors are thus correspondingly arranged at the same radial distance to be alternately aligned with the magnetic field when the movable part takes the first or second angular position.

The sensors can be advantageously arranged on a surface orthogonal to the axis of rotation of the movable part such to be aligned with magnetic fields in the direction of said axis. This way the magnetic field is always in a position perpendicular to the sensor when the magnet faces the same during the rotation.

Advantageously the third position of the movable part corresponds to an angular position of the magnet such that the field thereby generated does not interfere with the operating range of the sensors, in particular it corresponds to an intermediate angular position between the first and second positions such that the deactivation of the sensors, and thus the commands to the reverse gear, occurs automatically through the passage of the magnet from a sensor the other one.

According to an embodiment, the movable part of the device has the shape of a disc-like element rotating about a shaft and wherein the magnet is inserted or anyway coupled such to be arranged at a given distance from the shaft and with the poles facing the same direction of the shaft.

According to an embodiment, the sensors are connected to a circuit susceptible of generating a signal operating an electronic switch when the magnetic field in proximity of the sensors is higher than a given threshold and for the time such field is higher than said threshold.

The electronic switch typically switches off the circuit driving an actuator for controlling the reverse gear.

Advantageously, each switches associated with the sensors drive a corresponding circuit controlling a solenoid of the same or different actuators such to move the control lever of the reverse gear in a direction when one of the two sensors detects a magnetic field or in the opposite direction when the other one of the two sensors detects a magnetic field, passing through an intermediate neutral situation corresponding to the absence of magnetic field detected by the sensors.

The device can comprise a control member rotatably coupled, through motion transmission members, to the movable part. The control member may have the shape of a lever or a handle selector angularly movable along a predetermined path and for a predetermined travel between two extreme stop positions corresponding to the first and second positions of the movable part of the device, the third position of the movable part corresponding to an intermediate position between the stop positions of the control member.

According to another aspect, object of the invention relates to a control system for boats comprising at least one control member for regulating the run direction of the boat, which control member is movable along a predetermined path and for a predetermined travel between a first e a second extreme stop positions, control means, which control means comprise at least one motorized driving actuator connected to a movable member regulating the travel condition of the motor, such as for example the control lever of the reverse gear, and which motorized actuator is connected to a control unit, which control unit generates signals controlling the motorized actuator corresponding to the position of the control member. The control member is coupled with a device as described, wherein the first and second positions of the movable part correspond to the first and second stop positions respectively of the control member or vice versa with the third position of the movable part corresponding to an intermediate position between the two stop elements of the control member. The device is connected with the control unit to send a forward or reverse command such to move the actuator in one direction or in the opposite direction at the stop positions of the control member.

Further object of the invention is a kit for the electronic control of the reverse gear of a boat comprising a motorized actuator intended to be coupled to the control lever of the reverse gear, a control member, such as a lever or a selector, for regulating the run direction of the boat, which control member is intended to be mounted on the bridge of a boat and a control device as described connectable to the control member to send commands operating the actuator depending on the position of the control member to accomplish a control system for boats according to the invention.

Further characteristics and improvements are object of the sub-claims.

The characteristics of the invention and the advantages deriving therefrom will be much clearer from the following specification of the accompanying figures, wherein:

Figs. 1 and 2 show a cross sectional view of the device according to an embodiment of the invention. In Fig. 1 the device is in the first operating position whereas in Fig. 2 it is in the second operating position.
Figs. 3 and 4 show a simplified block diagram of the driving circuit of a reverse gear with the position of the electronic switches depicted respectively in the first and second operating positions of the device.
Fig. 5 shows the operating principle of a Hall effect sensor.
Fig. 6 shows a control system for boats according to an embodiment of the invention.

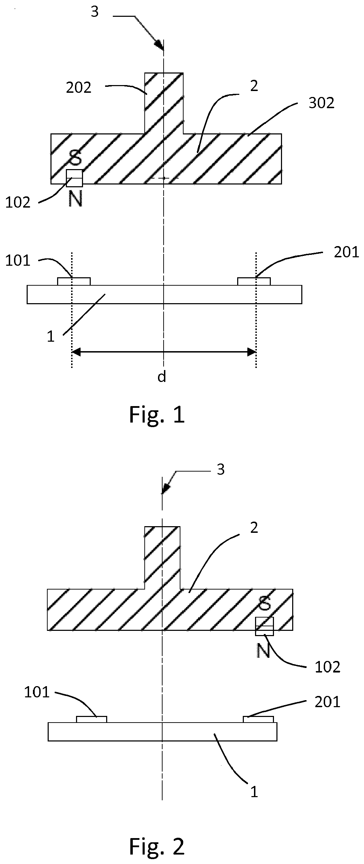

In reference to figures 1 and 2, the device according to the invention comprises a fixed part 1 and a movable part 2.

In its simplest form the movable part 2 is formed by a shaft 202 provided with a widening as a flange 302 on which a magnet 102 is mounted at a given distance d/2 from the axis 3.

Typically the poles of the magnet 102 face the same direction of the axis 3 such that the generated magnetic field B is orthogonal to the surface 302.

The fixed part consists of a surface on which two sensors 101, 201 are housed and able to detect the presence of an incident magnetic field. The surface is advantageously orthogonal to the axis of rotation 3 of the movable part 2 such that the magnetic field generated by the magnet 102 remains generally perpendicular to the surface, in particular in proximity of the sensors 101, 201.

The sensors 101, 201 are devices able to detect the presence of a magnetic field B. They are, for example, sensors exploiting the Hall effect, i.e. the formation of a potential difference on the opposite sides of an electric conductor due to a magnetic field perpendicular to the electric current flowing in the same.

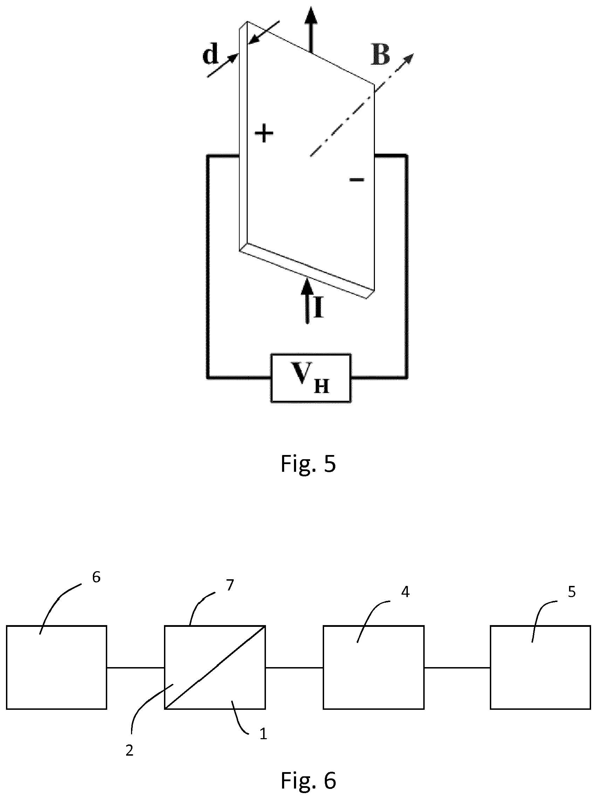

The physical principle of operation of a Hall effect sensor will be now referred in reference to Fig. 5.

Consider a strip of conducting material (Hall element) wherein a current I is made flow. When the Hall element is immersed in a magnetic field B having a direction tilted with respect to the surface of the element, typically perpendicular thereto, electrons conducing the current I are affected by the magnetic field. On them the Lorentz force acts

$$\vec{F} = q\vec{v} x \vec{B}$$

where:
q is the electron charge, v its speed and B is the magnetic field.

The force has a direction perpendicular to I and B and, thus, such to generate a potential difference $V_H$ at the sides of the surface, as shown in figure.

This results in generating a voltage which can be detected to determine whether or not the conductor is crossed by a magnetic field.

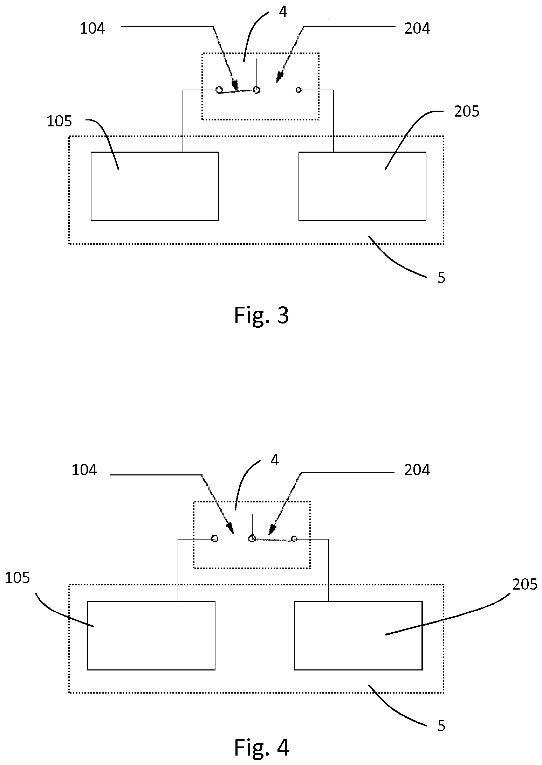

Turning to the device according to the invention, the Hall voltage generated by the sensors 101, 201, when the magnet 102 passes in proximity of each one of them, is advantageously used by the electronics 4 to accomplish a pair of electronic switches 104, 204 as shown in figures 3 and 4. It is in practice a pair of threshold comparator circuits able to drive the switch off of a circuit when the output voltage from the respective sensor is higher than a given value for a given period of time, thus making a typical monostable device usually commercially available.

In Fig. 3 the situation is shown wherein the switch 104, corresponding to the sensor 101, is switched off whereas the switch 204, corresponding to the sensor 201, is switched on. Fig. 4 shows on the contrary the opposite situation wherein the switch 104 is switched on whereas the switch 204 is switched off.

The two switches 104, 204 can never switch off simultaneously due to the particular structure of the device according to the invention.

In fact, the sensors are arranged in staggered angular positions such that the magnetic field generated by the magnet 102 can interfere with the operating range of a single sensor at a time. In Fig. 1 and 2 the sensors are arranged at 180° i.e. in diametrically opposed positions, but also different angular staggerings can of course be used as long as the same distance from the axis 3 equal to d/2 is kept so as to ensure the existence of a first and second angular positions of the movable part 2 in which the magnet 102, during the rotation, faces the first and second sensors respectively.

In the first position shown in Fig. 1, the sensor 101 detects the presence of the magnetic field generated by the magnet 102, allowing the switching off of the switch 104, whereas in the second position the second sensor 201 detects the magnetic field and correspondingly determines the switching off of the switch 204.

Each angular position of the movable part of the device, different with respect to these two ones, implies the absence of magnetic field in proximity of the sensors and, thus, the corresponding switching on of both the switches.

Therefore, the device takes substantially three operating positions corresponding to the switching off of a switch, to the switching on of both the switches and to the switching off of the other switch, as required in case of driving the reverse gear of a boat.

In fact, by connecting the electronic switches 104, 204 with a pair of solenoids 105, 205 of the same or different actuators, forward or reverse motion commands can be sent to the boat without the need of taking care of bringing the reverse gear back to the neutral position before reversing the rotation of the propeller.

Assuming, by way of example, that the first switch 104 is connected to the solenoid 105 of the forward motion and the second actuator 204 is connected to the solenoid 205 of the reverse motion of the actuator, the motor will be neutral when the movable part 2 of the device is in any intermediate position between the two switch off positions of the switches. By rotating the movable part 2 such to superimpose the magnet with the sensor 101, the switch 104 is switched off thus sending a forward motion command. By rotating in the opposite direction corresponding to the superimposition of the magnet with the sensor 201, a reverse motion command will be sent and anyway will be preceded by a neutral command due to the forced passage of the magnet in an area wherein none of the two sensors is activated. The same as regard to the opposite sequence, i.e. the deactivation of the reverse motion to proceed to the forward motion.

The rotation of the movable part 2 can be advantageously carried out by a control member (not shown in figures) that can, for example, take the shape of a disc-like or handle selector angularly movable along a predetermined path and for a predetermined travel between two extreme stop positions corresponding to the positions of the movable part (2) of the device determining the switching off of the switches.

Fig. 6 shows a control system for boats according to an embodiment of the invention.

The system comprises at least one control member 6 for regulating the run direction of the boat, which control member 6 is movable along a predetermined path and for a predetermined travel between a first and a second extreme stop position. There are control means comprising at least one motorized driving actuator 5 connected to a movable member regulating the travel condition of the motor, such as for example the control lever of the reverse gear. The motorized actuator 5 is connected to a control unit 4 generating signals controlling the motorized actuator 5 corresponding to the position of the control member by means of a device 7 afore described and coupled thereto. The first and second positions of the movable part 2 of the device correspond to the first and second stop positions respectively of the control member 6 or vice versa and the third position of the movable part 2 corresponds to an intermediate position between the two stop elements of the control member. The device 7 is connected with the control unit 4 to send a forward or reverse motion command such to move the actuator 5 in a direction or in the opposite direction at the stop positions of the control member 6.

The control unit can be an electronic one intended to generate commands to the actuator based on signals coming from the sensors of the device 7 or be the same electronics intended to control the whole boat.

The device can be widely varied. For example the magnet can be arranged axially with the sensors arranged along a curved surface acting as a stator for the movable part which takes the shape of a true motor. Also the magnet orientation can be varied as long as the magnetic field generated thereby has strength, direction and orientation such to be alternately detected by the sensors at specific angular positions.

The magnet can also be made of ferromagnetic material closing a magnetic circuit present in the sensor, generating a similar effect, or the movable part and the fixed part can be switched and the rotating part can house the sensors with the fixed part carrying the magnet or the ferromagnetic element facing the sensors during the rotation. All without departing from the guiding principle stated afore and claimed in the following.

**Claims**

1. Device (7) for controlling reverse gears, particularly of marine engines, **characterized in that** it comprises a fixed part (1) and a movable part (2), the movable part being provided for being rotatably coupled to a control member (6) having at least three operating states corresponding to a first, a second and a third angular position of the movable part of the device, the fixed part (1) comprising at least one first (101) and one second sensor (201) arranged at a predetermined distance and able to detect the presence of a magnetic field, the movable part (2) comprising a magnet (102) with such characteristics to generate a magnetic field that is detected by the first (101) or second sensor (201) when the movable part is in the first or in the second position respectively or vice versa, the third position corresponding to a situation of absence of magnetic field detectable by the sensors.

2. Device according to claim 1, wherein the magnet (102) is integral with an element intended to rotate about an axis (3) such to generate a rotating magnetic field with constant strength, the sensors (101, 201) being arranged in staggered angular positions such that the magnetic field interferes with the operating range of the sensors when the magnet (102) is in proximity of said sensors (101, 201) .

3. Device according to claim 1 or 2, wherein the magnet (102) is oriented with the poles parallel to the axis of rotation (3), the magnetic field taking the direction of the generatrix of a cylinder with circular base with radius equal to the distance of the magnet from the axis of rotation (3), the sensors (101, 201) being correspondingly arranged at the same radial distance such to be alternately aligned with the magnetic field when the movable part takes the first or second angular position.

4. Device according to one or more of the preceding claims, wherein the third position of the movable part corresponds to an angular position of the magnet (102) such that the field the latter generates does not interfere with the operating range of the sensors (101, 201).

5. Device according to claim 4, wherein the third position of the movable part corresponds to an intermediate angular position between the first and second position.

6. Device according to one or more of the preceding claims, wherein the movable part (2) has the shape of a disc-like element rotating about a shaft (3), the magnet (102) being inserted or anyway coupled with said disc-like element such to be arranged at a given distance from the shaft (3) and with the poles facing the same direction of the shaft (3) .

7. Device according to one or more of the preceding claims, wherein the sensors (101, 201) are arranged on a surface orthogonal to the axis of rotation (3) of the movable part (2) such to be aligned with the magnetic fields in the direction of said axis.

8. Device according to one or more of the preceding claims, wherein the sensors (101, 201) are elements generating a voltage when subjected to an external magnetic field due to Hall effect.

9. Device according to one or more of the preceding claims, wherein the sensors are connected to a circuit (4) susceptible of generating a signal operating an electronic switch (104, 204) when the magnetic field in proximity of the sensors is higher than a given threshold and for the time such field is higher than said threshold.

10. Device according to claim 9, wherein the electronic switch (104, 204) switches off the circuit driving an actuator (5) for controlling the reverse gear.

11. Device according to claim 9 or 10, wherein each switches (104, 204) associated with the sensors (101, 201) drive a corresponding circuit controlling a solenoid (105, 205) of the same or different actuators (5) such to move the control lever of the reverse gear in a direction when one of the two sensors detects a magnetic field or in the opposite direction when the other one of the two sensors detects a magnetic field, passing through an intermediate neutral situation corresponding to the absence of magnetic field detected by the sensors.

12. Device according to one or more of the preceding claims, **characterized in that** it comprises a control member (6) rotatably coupled, through motion transmission members, to the movable part (2) of the device, said member (6) having the shape of a lever or a handle selector angularly movable along a predetermined path and for a predetermined travel between two extreme stop positions corresponding to the first and second positions of the movable part (2) of the device, the third position of the movable part (2) corresponding to an intermediate position between the stop positions of the control member (6).

13. Control system for boats, comprising at least one control member (6) for regulating the run direction of the boat, which control member (6) is movable along a predetermined path and for a predetermined travel between a first and a second extreme stop positions, control means, which control means comprise at least one motorized driving actuator (5) connected to a movable member regulating the travel condition of the motor, such as for example the control lever of the reverse gear, and which motorized actuator (5) is connected to a control unit (4), which control unit (4) generates signals controlling the motorized actuator (5) corresponding to the position of the control member, **characterized in that** the control member (6) is coupled with a device (7) according to one or more of the preceding claims wherein the first and second positions of the movable part (2) correspond to the first and second stop positions respectively of the control member (6) or vice versa and the third position of the movable part (2) corresponds to an intermediate position between the two stop elements of the control member, the device (7) being connected with the control unit (4) to send a forward or reverse command such to move the actuator (5) in one direction or in the opposite direction at the stop positions of the control member (6).

14. Kit for the electronic control of the reverse gear of a boat comprising a motorized actuator (5) intended to be coupled to the control lever of the reverse gear, a control member (6) for regulating the run direction of the boat, which control member (6) is intended to be mounted on the bridge of a boat, a control device (7) according to one or more of claims 1 to 12 connectable to the control member (6) to send commands operating the actuator (5) depending on the position of the control member (6) to accomplish a control system, for boats according to claim 13.

3

202    2    302

S

N

102

101    201

1

d

Fig. 1

3

2

S

N

102

101    201

1

Fig. 2

104    4    204

105    205

5

Fig. 3

104    4    204

105    205

5

Fig. 4

Fig. 5

Fig. 6

Europäisches
Patentamt

European
Patent Office

Office européen
des brevets

# EUROPEAN SEARCH REPORT

**Application Number**

EP 18 16 7421

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/092447 A1 (FREER BENJAMIN AVERY [US] ET AL) 30 March 2017 (2017-03-30) | 1-9,12 | INV. B63H21/21 |
| Y | * page 3, paragraph 0027 - paragraph 0029; figures 3-5 * | 10,11, 13,14 | |
| X | TW M 243 774 U (MATSUSHITA ELECTRIC TW CO LTD [TW]) 11 September 2004 (2004-09-11) * figures 2,3 * | 1-8,12 | |
| X | US 2011/221553 A1 (CHANG CHING-TANG [TW]) 15 September 2011 (2011-09-15) | 1,2,7-9 | |
| A | * page 2, paragraph 0021 - paragraph 0022; figures 6,7,8 * | 3,6 | |
| Y | US 3 140 689 A (MINER JOHN E) 14 July 1964 (1964-07-14) * column 2, line 27 - line 34; figures 1,2 * * column 2, line 60 - column 3, line 12 * | 10,11, 13,14 | |

**TECHNICAL FIELDS SEARCHED (IPC)**

B63H
H03K

| Place of search | Date of completion of the search | Examiner |
|---|---|---|
| The Hague | 14 June 2018 | Székely, Zsolt |

The present search report has been drawn up for all claims

## ANNEX TO THE EUROPEAN SEARCH REPORT
## ON EUROPEAN PATENT APPLICATION NO.

EP 18 16 7421

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2018

| Patent document cited in search report | | Publication date | Patent family member(s) | | Publication date |
|---|---|---|---|---|---|
| US 2017092447 | A1 | 30-03-2017 | CA 2999877 A1<br>DE 112016003894 T5<br>US 2017092447 A1<br>WO 2017058671 A1 | | 06-04-2017<br>30-05-2018<br>30-03-2017<br>06-04-2017 |
| TW M243774 | U | 11-09-2004 | NONE | | |
| US 2011221553 | A1 | 15-09-2011 | TW 201131609 A<br>US 2011221553 A1<br>US 2014218142 A1<br>US 2014232496 A1 | | 16-09-2011<br>15-09-2011<br>07-08-2014<br>21-08-2014 |
| US 3140689 | A | 14-07-1964 | NONE | | |

EPO FORM P0459

For more details about this annex : see Official Journal of the European Patent Office, No. 12/82

**EP 3 392 132 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5466996 A

- US 6587765 B